# EUROPÄISCHE PATENTANMELDUNG

(11) **EP 4 475 170 A1**
(43) Veröffentlichungstag der Anmeldung: **11.12.2024**
(21) Anmeldenummer: 23177784.8
(22) Anmeldetag: 06.06.2023
(51) Int. Cl.: H01L 21/687, G01N 21/95, H01L 21/67

(54) **HALTEVORRICHTUNG FÜR EINE HORIZONTAL ANGEORDNETE SCHEIBE AUS HALBLEITERMATERIAL**

(71) Anmelder: Siltronic AG, 81677 München (DE)
(72) Erfinder: Herold, Andreas, 09526 Olbernhau (DE); Stenzel, Frank, 09599 Freiberg (DE)
(74) Vertreter: Grundner, Sebastian

(57) **Zusammenfassung**

Haltevorrichtung für eine horizontal angeordnete Scheibe (30) aus Halbleitermaterial, umfassend mindestens ein Grundelement (10) und mehrere Auflageelemente (20) zur Auflage der Scheibe (30) aus Halbleitermaterial, wobei
das mindestens eine Grundelement (10) aus einer Metalllegierung und die mehreren Auflageelemente (20) aus einer Kunststoffzusammensetzung bestehen,
die mehreren Auflageelemente (20) konzentrisch angeordnet sind,
die mehreren Auflageelemente (20) azimutal formschlüssig und in Radialauswärtsrichtung formschlüssig auf dem mindestens einen Grundelement (10) lösbar befestigt sind,
die mehreren Auflageelemente (20) an der radialinwärtsliegenden Seite Vorsprünge (21) zur Randauflage der Scheibe (30) aus Halbleitermaterial aufweisen, und
die Oberfläche an der Oberseite der Vorsprünge (21) in Radialinwärtsrichtung nach unten abfällt.

## Beschreibung

### Technisches Gebiet

Gegenstand der vorliegenden Erfindung ist eine Haltevorrichtung für eine horizontal angeordnete Scheibe aus Halbleitermaterial und die Verwendung der Haltevorrichtung in einem Messgerät.

### Stand der Technik

Scheiben aus Halbleitermaterial, insbesondere Scheiben aus monokristallinem Silizium, sind die Grundlage der modernen Elektronik. Während der Herstellung von modernen Bauelementen auf besagten Halbleiterscheiben werden thermische Prozesse mit mittlerweile recht komplexen Beschichtungsschritten durchgeführt.

Um Sicherzustellen, dass die Scheiben aus Halbleitermaterial den hohen Qualitätsanforderungen genügen, ist eine strenge Prozesskontrolle und Inspektion der produzierten Scheiben erforderlich. Dabei kommt der Oberflächeninspektion, insbesondere der Streulichtinspektion, der Scheiben eine große Bedeutung in der Qualitätssicherung zu. Die Inspektion von Scheiben aus Halbleitermaterial hinsichtlich Kontamination und Beschädigung mit Hilfe von optischen Verfahren ist beispielsweise in der DE 102 37 477 B4 beschrieben. Die DE 102 37 477 B4 beschreibt ein Streulichtinspektionsgerät, mit dem die Oberfläche einer schnell rotierenden Scheibe mit einem Laser spiralförmig abgetastet wird. Dabei wird die Scheibe von einer drehbaren Haltevorrichtung gehalten, auf der die Scheibe platziert und in Rotation versetzt wird. Eine solche Halte- und Drehvorrichtung ist beispielsweise in der DE 10 2006 045 866 A1 beschrieben.

Die DE 10 2004 036 435 A1 beschreibt einen Probenhalter mit schwenkbaren Greiffingern zur Fixierung einer Halbleiterscheibe auf dem Halter, wobei die Greiffinger in Haltestellung mittels mindestens einem Vorspannelement vorgespannt sind.

Vibrationen, Verformung oder ein Verrutschen der Scheibe während der Rotation würde zu einer Beeinträchtigung der Messung führen. Deshalb muss die Halte- und Drehvorrichtung eine stabile Lagerung der rotierenden Scheibe auch bei hohen Drehzahlen von bis zu über 1000 Umdrehungen pro Minute sicherstellen und Verformung und Schwingung minimieren. Außerdem soll die Scheibe möglichst nicht von der Halterung verdeckt werden, damit auch der Randbereich der Scheibe für die Oberflächeninspektion zugänglich ist. Dies ist gerade bei der Rückseiteninspektion der Scheibe eine Herausforderung.

Aus wirtschaftlichen Gründen ist eine hohe Lebensdauer der Halterung wünschenswert, was gerade aufgrund der hohen Drehzahlen von bis zu über 1000 Umdrehungen pro Minute herausfordernd ist.

Halte- und Drehvorrichtungen mit Greifern können zwar einerseits eine stabile Fixierung der Scheibe bei hohen Drehzahlen ermöglichen. Jedoch ist hier ein Teil der Oberfläche einer Seite der Scheibe durch den Greifer verdeckt und für die Inspektion nicht zugänglich. Zudem soll die Halterung die empfindliche Oberfläche der Scheibe nicht mechanisch beschädigen oder zur Verunreinigung der Scheibe mit Fremdstoffen führen. Bei der Verwendung von Greifern besteht jedoch die Gefahr, dass diese die empfindliche Oberfläche einer Scheibe beschädigen.

Haltevorrichtungen aus einem Edelstahlträger mit einer aufgeklebten Kunststofffolie, die als Auflagefläche für eine Scheibe aus Halbleitermaterial dient, finden ebenfalls Verwendung in der Halbleiterindustrie. Die Kunststofffolie verhindert eine Verunreinigung der Scheibe mit Metallen und das Verkratzen der Rückseite der Scheibe. Außerdem wirkt die Kunststofffolie schwingungsdämpfend. Jedoch ist eine dauerhafte, stabile Anhaftung der Folie auf dem Metallträger aufwendig und nur von relativ kurzer Dauer, zudem wartungsanfällig und für die Qualitätssicherung nur eingeschränkt geeignet.

### Technische Aufgabe der Erfindung und deren Lösung

Aufgabe der vorliegenden Erfindung ist die Bereitstellung einer Haltevorrichtung für eine horizontal angeordnete Scheibe aus Halbleitermaterial, die diese Probleme löst. Insbesondere ist es die Aufgabe der vorliegenden Erfindung, eine Haltevorrichtung für eine horizontal angeordnete Scheibe aus Halbleitermaterial bereitzustellen, die eine stabile Lage der Scheibe auch bei hohen Drehzahlen ermöglicht, Beschädigung und Verunreinigung der Scheibe durch den Probenhalter verhindert, und die außerdem eine hohe Lebensdauer aufweist.

Gelöst wird diese Aufgabe durch die erfindungsgemäße Haltevorrichtung für eine horizontal angeordnete Scheibe aus Halbleitermaterial. Die erfindungsgemäße Haltevorrichtung umfasst mindestens ein Grundelement (10) und mehrere Auflageelemente (20) zur Auflage der Scheibe (30) aus Halbleitermaterial, wobei
das mindestens eine Grundelement (10) aus einer Metalllegierung und die mehreren Auflageelemente (20) aus einer Kunststoffzusammensetzung bestehen,
die mehreren Auflageelemente (20) konzentrisch angeordnet sind,
die mehreren Auflageelemente (20) azimutal formschlüssig und in Radialauswärtsrichtung formschlüssig auf dem mindestens einen Grundelement (10) lösbar befestigt sind,
die mehreren Auflageelemente (20) an der radialinwärtsliegenden Seite Vorsprünge (21) zur Randauflage der Scheibe (30) aus Halbleitermaterial aufweisen, und
die Oberfläche an der Oberseite der Vorsprünge (21) in Radialinwärtsrichtung nach unten abfällt.

Es wurde überraschend festgestellt, dass die erfindungsgemäße Haltevorrichtung auch bei hohen Drehzahlen eine stabile Auflage einer Scheiben aus Halbleitermaterial ermöglicht. Außerdem wurde beobachtet, dass die bei hohen Drehzahlen auftretenden Vibrationen und Schwingungen der Scheibe im Vergleich zu konventionellen Probehaltern deutlich verringert werden konnten. Außerdem wurde eine hohe Lebensdauer der Haltevorrichtung, insbesondere der Auflageelemente, festgestellt.

### Kurzbeschreibung der Figuren

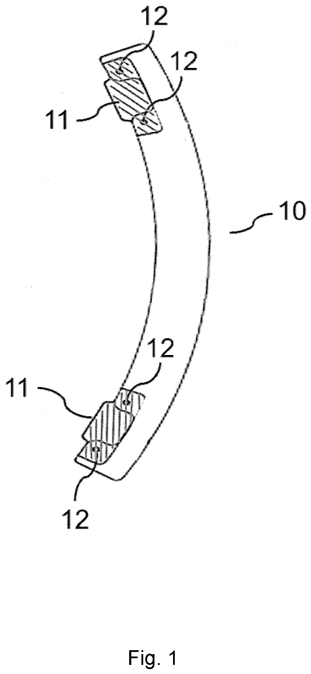

**Fig. 1** zeigt schematisch ein bogenförmiges Grundelement (10) für eine erfindungsgemäße Haltevorrichtung. Dabei weist das Grundelement (10) Aussparungen (11) auf, in die Auflageelemente azimutal formschlüssig und in Radialauswärtsrichtung formschlüssig befestigt werden können. Die Aussparungen (11) sind mit Bohrungen (12) versehen, über die das Auflageelement mit dem Grundelement lösbar befestigt werden kann, beispielsweise durch Verschraubung.

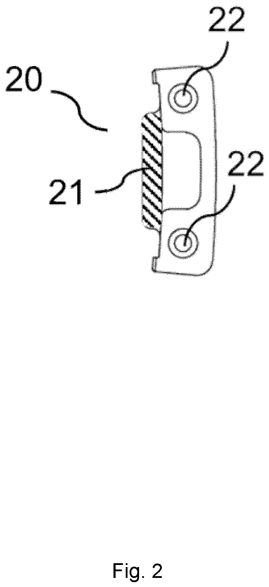

**Fig. 2** zeigt schematisch ein Auflageelement (20) für eine erfindungsgemäße Haltevorrichtung. Dabei weist das Auflageelement (20) an der radialinwärtsliegenden Seite einen Vorsprung (21) zur Randauflage der Scheibe aus Halbleitermaterial auf. Das Auflageelement ist mit Bohrungen (22) versehen, über die das Auflageelement mit dem Grundelement lösbar befestigt werden kann, beispielsweise durch Verschraubung.

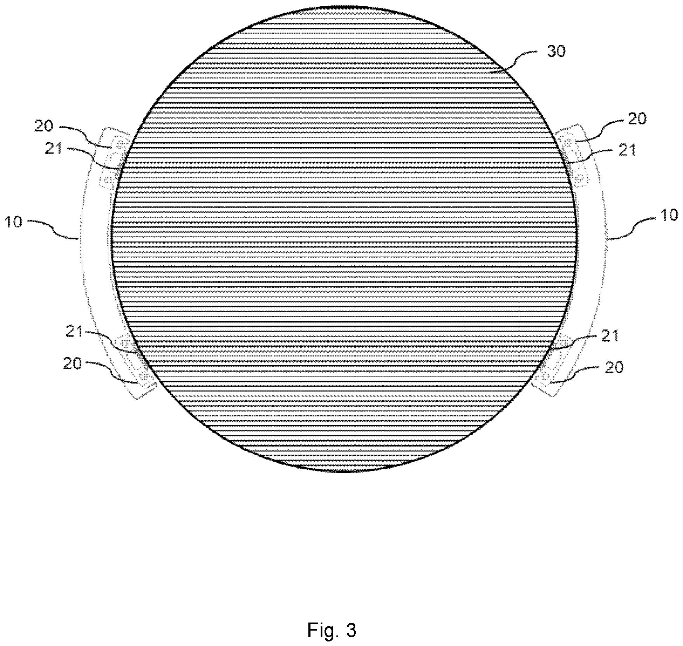

**Fig. 3** zeigt schematisch eine erfindungsgemäße Haltevorrichtung für eine horizontal angeordnete Scheibe (30) aus Halbleitermaterial, umfassend zwei Grundelemente (10) mit jeweils zwei darauf angeordneten Auflageelementen (20). Die Auflageelemente (20) sind azimutal formschlüssig und in Radialauswärtsrichtung formschlüssig auf den Grundelementen (10) lösbar befestigt. Die Auflageelemente (20) weisen an ihrer radialinwärtsliegenden Seite Vorsprünge (21) zur Randauflage der Scheibe (30) aus Halbleitermaterial auf.

### Detaillierte Beschreibung der Erfindung

Die erfindungsgemäße Haltevorrichtung ist so ausgestaltet, dass sie eine horizontal angeordnete Scheibe aus Halbleitermaterial aufnehmen kann.

Die Scheibe aus Halbleitermaterial hat vorzugsweise einen Durchmesser von 150 mm bis 450 mm, besonders bevorzugt 200 mm bis 300 mm, am meisten bevorzugt 200 mm oder 300 mm. Die Scheibe aus Halbleitermaterial ist vorzugsweise eine Scheibe aus einkristallinem Silizium. Die Scheibe aus Halbleitermaterial kann auch mittels Abscheidung aus der Gasphase mit Germanium, Siliziumcarbid oder Galliumnitrid beschichtet sein. Der Rand der Scheibe ist vorzugsweise abgerundet. Der abgerundete Rand der Scheibe ist definiert als der radiale, ringförmige Randbereich, in dem sich die Dicke der Scheibe in Radialauswärtsrichtung verringert oder verjüngt. Dabei ist unter der Dicke der Scheibe die axiale Ausdehnung senkrecht zur radialen Richtung zu verstehen, also senkrecht zu den Hauptflächen an der Vorder- und Rückseite der Scheibe.

Die erfindungsgemäße Haltevorrichtung ist vorzugsweise so ausgestaltet, dass sie eine horizontal angeordnete Scheibe aus Halbleitermaterial mit einem Durchmesser von nicht weniger als 200 mm und nicht mehr als 300 mm aufnehmen kann. Die Haltevorrichtung ist dabei vorzugsweise so ausgestaltet, dass die horizontal angeordnete Scheibe nur auf der abfallenden Oberfläche an der Oberseite der Vorsprünge der Auflageelemente aufliegt. In einer Ausführungsform ist die Haltevorrichtung so ausgestaltet, dass eine horizontal angeordnete Scheibe aus Halbleitermaterial mit einem Durchmesser von 200 mm nur auf der abfallenden Oberfläche an der Oberseite der Vorsprünge der Auflageelemente aufliegt. In einer andere Ausführungsform ist die Haltevorrichtung so ausgestaltet, dass eine horizontal angeordnete Scheibe aus Halbleitermaterial mit einem Durchmesser von 300 mm nur auf der abfallenden Oberfläche an der Oberseite der Vorsprünge der Auflageelemente aufliegt.

Die Grundelemente sind aus einer Metalllegierung gefertigt, vorzugsweise aus Edelstahl. Durch die Grundelemente aus einer Metalllegierung ist eine hohe Stabilität und Steifigkeit der Haltevorrichtung insgesamt beim Beschleunigen oder Abbremsen der Drehbewegung und bei hohen Rotationszahlen gewährleistet. Die Grundelemente der Haltervorrichtung berühren andere Bauteile, beispielsweise die eines Inspektionsgerätes oder eines drehbar gelagerten Tisches. Somit kann durch die Wahl einer verschleißfesten Metalllegierung als Material der Grundelemente die Lebensdauer der Haltevorrichtung erhöht werden. Die Metalllegierung ist vorzugsweise eine Stahllegierung, eine Kupferlegierung, eine Messinglegierung, oder eine Titanlegierung, besonders bevorzugt eine Edelstahllegierung. Die Grundelemente sind vorzugsweise bogenförmig ausgestaltet. Vorzugsweise umfasst die Haltevorrichtung zwei Grundelemente, die symmetrisch an einem drehbar gelagerten Tisch lösbar befestigt sind.

Das mindestens eine Grundelement ist dabei so ausgestaltet, dass mehrere Auflageelemente azimutal formschlüssig und in Radialauswärtsrichtung formschlüssig auf dem mindestens einen Grundelement lösbar befestigt werden können. Vorzugsweise hat das Grundelement (10), wie in Fig. 1 dargestellt, an seiner Oberseite mindestens eine Aussparung (11), die eine formschlüssige Verbindung in azimutale Richtung und in Radialauswärtsrichtung ermöglicht. Zur lösbaren Befestigung der Auflageelemente sind die Aussparungen (11) des Grundelements (10) mit Bohrungen (12) versehen. Die azimutale Richtung und die Radialauswärtsrichtung werden dabei durch die konzentrisch angeordneten Auflageelemente definiert. Dadurch, dass die Auflageelemente azimutal formschlüssig und in Radialauswärtsrichtung formschlüssig auf den Grundelementen lösbar befestigt sind, ist ein einfacher Austausch der Auflageelemente ohne Justierung möglich, so dass eine Erneuerung der Auflageelemente oder deren Anpassung, beispielsweise an eine neue Randgeometrie der Scheiben, einfach, schnell und kostengünstig möglich ist. Vorzugsweise sind die Bohrungen in den Auflageelemente so ausgestaltet, dass Schrauben darin vollständig versenkt werden können. Dadurch kann eine Berührung von Schrauben und der Scheibe aus Halbleitermaterial bei der Auflage oder Entnahme der Scheibe verhindert werden.

Vorzugsweise ist das mindestens eine Grundelement dabei so ausgestaltet, dass zwei Auflageelemente azimutal formschlüssig und in Radialauswärtsrichtung formschlüssig daran lösbar befestig werden können. Als Befestigungsmittel zur lösbaren Befestigung der Auflageelemente auf dem mindestens einen Grundelement werden vorzugsweise Schrauben verwendet. In einer bevorzugten Ausführungsform haben die Grundelemente Vorsprünge, die so ausgestaltet sind, dass die gesamte Unterseite der Auflageelemente auf dem Grundelement aufliegt. Somit liegen in dieser Ausführungsform auch die Vorsprünge zur Randauflage auf dem Grundelement auf und werden so von diesem gestützt. Dies erhöht die Stabilität und Steifigkeit der Vorsprünge zur Randauflage und verbessert die Fixierung der Scheibe auf der Haltevorrichtung bei hohen Drehzahlen von über 1000 Umdrehungen pro Minute. Außerdem können so Schwingungen und Vibrationen der Scheibe weiter reduziert werden.

Die Auflageelemente bestehen aus einer Kunststoffzusammensetzung. Die Kunststoffzusammensetzung ist vorzugsweise frei von Metallen, um eine Verunreinigung der Scheiben aus Halbleitermaterial mit Metallen durch die Haltevorrichtung zu vermeiden. Die Kunststoffzusammensetzung umfasst vorzugsweise Hart-Polyethylen. In einer Ausführungsform werden die Auflageelemente mittels eines Spritzgussverfahrens hergestellt. In einer bevorzugten Ausführungsform werden die Auflageelemente mittels eines Spritzgussverfahrens aus einem UV-stabilisierten Kunststoffharz, vorzugsweise einer Polymerzusammensetzung, die UV-stabilisiertes Hart-Poylethylen-Harz enthält, hergestellt. Hart-Polyethylen wird oft auch als High Density Polyethylen (HDPE) bezeichnet und ist sehrt stabil und widerstandsfähig. Die Kunststoffzusammensetzung umfasst vorzugsweise 50 bis 99 Gew.-% Hart-Polyethylen, besonders bevorzugt 70 bis 95 Gew.-% Hart-Polyethylen. In einer besonders bevorzugten Ausführungsform werden die Auflageelemente aus dem Material HDPE KT 10000 UE des Herstellers Dow Chemical hergestellt. Die Kunststoffzusammensetzung kann aber auch andere Polymere anstatt Polyethylen umfassen, solange die Verarbeitbarkeit der Kunststoffzusammensetzung mittels eines Spritzgussverfahrens gewährleistet ist. So kann die Kunststoffzusammensetzung beispielsweise auch ein oder mehrere Polymere ausgewählt aus der Gruppe von Polyamiden, Polyestern, Polyphenolen Epoxidharzen, Silikonen oder Polypropylen umfassen.

Dadurch, dass die Auflageelemente aus einer Kunststoffzusammensetzung, vorzugsweise eine Zusammensetzung, die Hart-Polyethylen umfasst, ausgestaltet sind, haben sie im Vergleich zu Bauteilen aus einer Metalllegierung bessere Dämpfungseigenschaften. Durch die verbesserten Dämpfungseigenschaften der Auflageelemente können die bei hohen Drehzahlen auftretenden Vibrationen gedämpft und so die Schwingungen der Scheibe reduziert werden. Dadurch kann die Qualität der Oberflächeninspektion verbessert werden. Außerdem kann durch die geringere Härte der Kunststoffzusammensetzung im Vergleich zu einer Metalllegierung, zusammen mit ihrer schwingungsdämpfenden Wirkung, eine Beschädigung der empfindlichen, polierten Oberflächen der Scheiben, beispielsweise ein Verkratzen, vermieden werden.

Vorzugsweise hat die Kunststoffzusammensetzung eine Zugschlagfestigkeit von nicht weniger als 50 kJ/m², mehr bevorzugt von nicht weniger als 70 kJ/m², wobei die Zugschlagfestigkeit gemäß der Prüfmethode ASTM D1822 bestimmt wird. Wenn die Kunststoffzusammensetzung eine Zugschlagfestigkeit von nicht weniger als 50 kJ/m² aufweist, können die bei hohen Drehzahlen auf die Auflageelemente einwirkenden Kräfte gut von dem Material aufgenommen werden, ohne dass es zu Brüchen oder Rissen des Materials kommt. Eine hohe Zugschlagfestigkeit kann somit die Lebensdauer der Auflageelemente und damit der erfindungsgemäßen Haltevorrichtung insgesamt erhöhen.

Die Auflageelemente (20) sind in der erfindungsgemäßen Haltevorrichtung konzentrisch angeordnet, und weisen an der radialinwärtsliegenden Seite Vorsprünge (21) zur Randauflage der Scheibe (30) aus Halbleitermaterial auf, wie Fig. 2 und 3 zu entnehmen ist. Wie in Fig. 3 dargestellt, sind die Auflageelemente so ausgestaltet, dass eine auf der Haltevorrichtung platzierte Scheibe aus Halbleitermaterial (30) mit geeignetem Durchmesser, vorzugsweise mit einem Durchmesser von nicht weniger als 200 mm und nicht mehr als 300 mm, nur auf den Vorsprüngen (21) der Auflageelemente aufliegt und die Grundelemente (10) nicht berührt. In einer besonders bevorzugten Ausführungsform sind die Auflageelemente so ausgestaltet und angeordnet, dass eine Scheibe aus Halbleitermaterial mit einem Durchmesser von 300 mm nur auf den Vorsprüngen der Auflageelemente aufliegt. Wenn die Scheibe aus Halbleitermaterial nur mit der Kunststoffzusammensetzung der Auflageelemente, nicht aber mit der Metalllegierung der Grundelemente in Berührung ist, wird die Verunreinigung der Scheibe mit Fremdmetallen und die Übertragung der Schwingungen des Grundelements auf die Scheibe verhindert. Außerdem gewährleistet die im Vergleich zu Metalllegierungen weichere Kunststoffzusammensetzung eine stabile Auflage der Scheibe, ohne dass diese beschädigt wird.

Die Oberfläche an der Oberseite der Vorsprünge fällt in Radialinwärtsrichtung nach unten ab. Dadurch, dass die Oberfläche an der Oberseite der Vorsprünge in Radialinwärtsrichtung abfällt, wird eine Bewegung der Scheibe relativ zu den Auflageelementen selbst bei hohen Drehzahlen erschwert. Außerdem kann so die Kontaktfläche zwischen Scheibe und Auflageelementen weiter verringert werden, was die Inspektion des Randbereiches der Scheiben erleichtert. Durch ein Verrutschen der Scheibe, also eine Relativbewegung der Scheibe zur Haltevorrichtung, können Kratzer auf der Rückseite der Scheibe entstehen. Dadurch, dass eine Bewegung der Scheibe relativ zu den Auflageelementen verhindert wird und zusätzlich die Kontaktfläche zwischen Scheibe und Auflageelementen verringert wird, kann das Auftreten von Kratzern an der Rückseite der Scheibe deutlich verringert werden. Vorzugsweise sind die Vorsprünge so ausgestaltet, dass die Scheibe aus Halbleitermaterial nur mit ihrem abgerundeten Randbereich auf den Vorsprüngen aufliegt. Der abgerundete Rand der Scheibe aus Halbleitermaterial ist definiert als der radiale, ringförmige Randbereich der Scheibe, in dem sich die Dicke der Scheibe in Radialauswärtsrichtung verringert oder verjüngt.

Die Vorsprünge habe vorzugsweise eine radiale Ausdehnung von nicht weniger als 1 mm und nicht mehr als 5 mm, vorzugsweise nicht mehr als 1,5 und nicht mehr als 3,0 mm. Vorzugsweise entspricht die azimutale Ausdehnung der Vorsprünge, also die Ausdehnung senkrecht zur radialen Richtung dem 3-fachen bis 15-fachen Wert der radialen Ausdehnung, vorzugsweise dem 4-fachen bis 10-fachen Wert der radialen Ausdehnung. Wenn die Vorsprünge eine radiale Ausdehnung von nicht weniger als 1 mm und nicht mehr als 5 mm aufweisen, ist eine sichere Ablage und Entnahme der Scheibe auf und von der Haltevorrichtung und eine ausreichend stabile Auflage der Scheibe bei hohen Drehzahlen gewährleistet. Gleichzeitig wird nur ein geringer Teil der Rückseite der Scheibe von den Vorsprüngen verdeckt. Bei einer radialen Ausdehnung der Vorsprünge von nicht weniger als 1,5 mm und nicht mehr als 3 mm kann einerseits eine stabile, schwingungsarme Auflage der Scheibe auf den Auflageelementen gewährleistet und andererseits die Verdeckung der Rückseite durch die Vorsprünge minimiert werden.

Vorzugsweise ist mindestens ein Teil der Oberfläche an der Oberseite der Vorsprünge in radialer Richtung gewölbt. Die Vorsprünge sind vorzugsweise an ihren azimutalen Randbereichen gewölbt und weisen in ihrer azimutalen Mitte eine über ihre gesamte radiale Bereite verlaufende Aussparung auf. In einer Ausführungsform entspricht die in radialer Länge verlaufenden Aussparung nicht weniger als der Hälfte der azimutalen Breite der Vorsprünge. Die Aussparung ermöglicht die Ablage der Scheibe auf und ihre Entnahme von der Haltevorrichtung, da über die Aussparung ein Untergreifen der Scheibe durch ein Greifelement, beispielsweise einen Roboterarm, möglich ist. Vorzugsweise haben die Vorsprünge eine Wölbung mit einem Radius von nicht weniger als 2 mm und nicht mehr als 6 mm, vorzugsweise nicht weniger als 3 mm und nicht mehr als 5 mm. Die Neigung der Vorsprünge in Radialinwärtsrichtung beträgt vorzugsweise nicht weniger als 1,5° und nicht mehr als 5,0°. Die Neigung der Vorsprünge wird definiert durch eine Gerade, die in Radialinwärtsrichtung verläuft und den höchsten und den niedrigsten Punkt der Auflagefläche in dieser Richtung schneidet.

Die Oberfläche an der Oberseite der Vorsprünge weist eine Oberflächenrauheit von nicht mehr als 0,5 µm, vorzugsweise nicht mehr als 0,3 µm, am meisten bevorzugt nicht mehr als 0,1 µm, auf, wobei die Oberflächenrauheit gemäß der Prüfmethode DIN ISO 1302 bestimmt wird. Wenn die Oberfläche der Auflageelemente nicht ausreichend glatt ist, können an den Kontaktstellen der Scheibe mit der Auflagefläche Kratzer, Abdrücke oder Verunreinigungen durch Abrieb entstehen. Wenn die Oberflächenrauheit der Auflagefläche jedoch nicht mehr als 0,5 µm beträgt, kann dies verhindert werden. Die gewünschte, geringe Oberflächenrauheit kann durch ein Spritzgussverfahren erreicht werden. Dabei kann die Spritzgussform für die Auflageelemente an den Stellen der Vorsprünge nachbearbeitet werden, so dass eine besonders geringe Rauheit der Form und damit der mit der Form hergestellten Auflageelemente an diesen Stellen erzielt wird. Vorzugsweise erfolgt eine Hochglanzpolitur der Spritzgussform an den Stellen der Vorsprünge.

Das Spritzgussverfahren wird vorzugsweise mit einer Polymerzusammensetzung, die Polyethylen, vorzugsweise Hart-Polyethylen, umfasst durchgeführt. Vorzugsweise wird ein Polyethylen-Harz, besonders bevorzugt ein Hart-Polyethylen-Harz, beispielsweise HDPE KT 10000 UE des Herstellers Dow Chemical, eingesetzt. Vorzugsweise erfolgt das Spritzgussverfahren bei einer Massetemperatur von nicht weniger als 200°C und einem Spritzdruck von nicht weniger als 500 bar.

Die Auflageelemente können an ihrer radialinwärtsliegenden Seite zusätzlich Elemente zur Zentrierung der Scheibe aus Halbleitermaterial aufweisen. Die Elemente zur Zentrierung der Scheibe aus Halbleitermaterial sind an der radialinwärtsliegenden Seite der Auflageelemente als Vorsprünge mit einer kürzeren radialen und einer längeren axialen Ausdehnung im Vergleich zu den Vorsprüngen zur Randauflage der Scheibe ausgestaltet. Diese Elemente dienen als Anschlag für einen Roboterarm und erleichtern somit die Zentrierung der Scheibe auf der Haltevorrichtung und können eine mögliche Fehlablage durch den Roboter verhindern. Die Elemente zur Zentrierung der Scheibe aus Halbleitermaterial sind vorzugsweise im azimutalen Randbereich der radialinwärtsliegenden Seite eines Auflageelements so angeordnet, dass der Vorsprung des Auflageelements zur Ranauflage der Scheibe genau in ihrer azimutalen Mitte angeordnet ist.

Die erfindungsgemäße Haltevorrichtung wird vorzugsweise in einem Messgerät zur Oberflächeninspektion von Scheiben aus Halbleitermaterial verwendet. Das Messgerät zur Oberflächeninspektion ist dabei vorzugsweise ein Streulichtinspektionsgerät zur Oberflächeninspektion von Scheiben aus Halbleitermaterial. Die erfindungsgemäße Haltevorrichtung kann aber auch für Messgeräte zur Kanteninspektion mit Streulicht oder mittels bildgebender Verfahren, zur geometrischen Vermessung von Halbleiterscheiben, oder in einem ID-Reader eingesetzt werden.

Besonders vorteilhaft ist die Verwendung der erfindungsgemäßen Haltevorrichtung in einem Gerät zur Oberflächeninspektion der Rückseite einer Scheibe aus Halbleitermaterial. So wird durch die erfindungsgemäße Haltevorrichtung nur ein sehr geringer Anteil der Rückseite von der Halterung verdeckt und trotzdem eine stabile, schwingungsgedämpfte Lage der Scheibe auch bei hohen Drehzahlen gewährleistet.

### Detaillierte Beschreibung von erfindungsgemäßen Ausführungsbeispielen und von Vergleichsbeispielen

Im Ausführungsbeispiel 1 wurde eine erfindungsgemäße Haltevorrichtung für die horizontale Auflage einer Scheibe aus einkristallinem Silizium mit einem Durchmesser von 300 mm verwendet. Dabei wurden zwei identische, bogenförmige Grundelemente aus Edelstahl symmetrisch auf dem drehbar gelagerten Tisch einer Messvorrichtung des Herstellers Nanophotonics zur Oberflächeninspektion der Rückseite einer Scheibe angeordnet und lösbar befestigt. Auf jedem der beiden Grundelemente waren zwei Auflageelemente azimutal und in Radialauswärtsrichtung formschlüssig mit jeweils zwei Schrauben befestigt.

Die Auflageelemente wurden mittels eines Spritzgussverfahrens bei einer Massetemperatur von 240°C, einem Spritzdruck von 930 bar pro 0,9 Sekunden, einem Nachdruck von 800 bar pro 6 Sekunden und einem Staudruck von 120 bar aus einem Harz des Typs HDPE KT 10000 UE des Herstellers Dow Chemical hergestellt. Zuvor wurde die Spritzgussform an der Oberseite der Vorsprünge der Auflageelemente einer Politur unterzogen. Dadurch konnte die Rauheit der Oberfläche an der Oberseite der Vorsprünge auf 0,1 µm reduziert. werden. Die Rauheit wurde gemäß der Prüfmethode DIN ISO 1302 bestimmt. Die Vorsprünge an der radialinwärtsliegenden Seite der Auflageelement wiesen an ihren azimutalen Außenbereichen eine Wölbung in radialer Richtung mit einem Radius von 3.9 mm auf. Zwischen den beiden gewölbten Außenbereich wies der Vorsprung in der azimutalen Mitte eine Aussparung auf, die mehr als die Hälfte der azimutalen Länge der Vorsprünge einnahm.

In einem Vergleichsversuch wurde eine einteilige Haltevorrichtung verwendet, die aus einem Edelstahlträger bestand, auf dem eine Kunststofffolie aufgeklebt war. Die Kunststofffolie verhinderte zwar die Verunreinigung der aufliegenden Scheibe mit Metallen und ein Verkratzen der Scheibe. Jedoch war ein hoher Wartungsaufwand erforderlich, um das Ablösen der Folie zu überwachen und diese neu zu verkleben.

Hingegen wies die erfindungsgemäße Haltevorrichtung eine deutlich höhere Lebensdauer auf und erforderte eine deutlich weniger intensive Überwachung und Wartung der Haltevorrichtung. Außerdem konnte bei der erfindungsgemäßen Haltevorrichtung im Wartungsfall schnell und ohne komplizierte Justierung die Auflageelemente ausgetauscht werden.

## Patentansprüche

1. Haltevorrichtung für eine horizontal angeordnete Scheibe (30) aus Halbleitermaterial, umfassend mindestens ein Grundelement (10) und mehrere Auflageelemente (20) zur Auflage der Scheibe (30) aus Halbleitermaterial, wobei
das mindestens eine Grundelement (10) aus einer Metalllegierung und die mehreren Auflageelemente (20) aus einer Kunststoffzusammensetzung bestehen,
die mehreren Auflageelemente (20) konzentrisch angeordnet sind,
die mehreren Auflageelemente (20) azimutal formschlüssig und in Radialauswärtsrichtung formschlüssig auf dem mindestens einen Grundelement (10) lösbar befestigt sind,
die mehreren Auflageelemente (20) an der radialinwärtsliegenden Seite Vorsprünge (21) zur Randauflage der Scheibe (30) aus Halbleitermaterial aufweisen, und
die Oberfläche an der Oberseite der Vorsprünge (21) in Radialinwärtsrichtung nach unten abfällt.

2. Haltevorrichtung für eine horizontal angeordnete Scheibe aus Halbleitermaterial gemäß dem Anspruch 1, **dadurch gekennzeichnet, dass** mindestens ein Teil der Oberfläche an der Oberseite der Vorsprünge in radialer Richtung gewölbt ist.

3. Haltevorrichtung für eine horizontal angeordnete Scheibe aus Halbleitermaterial gemäß dem Anspruch 1 oder 2, **dadurch gekennzeichnet, dass** die Vorsprünge an ihrem Randbereichen gewölbt sind und in ihrer azimutalen Mitte eine über ihre gesamte radiale Bereite verlaufende Aussparung aufweisen.

4. Haltevorrichtung für eine horizontal angeordnete Scheibe aus Halbleitermaterial gemäß einem der Ansprüche 1 bis 3, **dadurch gekennzeichnet, dass** die Kunststoffzusammensetzung Hart-Polyethylen umfasst.

5. Haltevorrichtung für eine horizontal angeordnete Scheibe aus Halbleitermaterial gemäß einem der Ansprüche 1 bis 4, **dadurch gekennzeichnet, dass** die Kunststoffzusammensetzung eine Zugschlagfestigkeit von nicht weniger als 50 kJ/m² gemäß der Prüfmethode ASTM D1822 aufweist.

6. Haltevorrichtung für eine horizontal angeordnete Scheibe aus Halbleitermaterial gemäß einem der Ansprüche 1 bis 5, **dadurch gekennzeichnet, dass** die Oberfläche an der Oberseite der Vorsprünge eine Oberflächenrauheit von nicht mehr als 0,5 µm gemäß der Prüfmethode DIN ISO 1302 aufweist.

7. Haltevorrichtung für eine horizontal angeordnete Scheibe aus Halbleitermaterial gemäß einem der Ansprüche 1 bis 6, **dadurch gekennzeichnet, dass** die Auflageelemente mittels eines Spritzgussverfahrens erhältlich sind.

8. Haltevorrichtung für eine horizontal angeordnete Scheibe aus Halbleitermaterial gemäß einem der Ansprüche 1 bis 7, **dadurch gekennzeichnet, dass** die Haltevorrichtung zwei Grundelemente umfasst, die symmetrisch an einem drehbar gelagerten Tisch lösbar befestigt sind, und dass auf jedem der zwei Grundelemente zwei Auflageelemente lösbar befestigt sind.

9. Haltevorrichtung für eine horizontal angeordnete Scheibe aus Halbleitermaterial gemäß einem der Ansprüche 1 bis 8, **dadurch gekennzeichnet, dass** die horizontal angeordnete Scheibe einen Durchmesser von 300 mm aufweist.

10. Haltevorrichtung für eine horizontal angeordnete Scheibe aus Halbleitermaterial gemäß einem der Ansprüche 1 bis 8, **dadurch gekennzeichnet, dass** die horizontal angeordnete Scheibe einen Durchmesser von 200 mm aufweist.

11. Haltevorrichtung für eine horizontal angeordnete Scheibe aus Halbleitermaterial gemäß einem der Ansprüche 1 bis 10, **dadurch gekennzeichnet, dass** die Haltevorrichtung so ausgestaltet ist, dass die horizontal angeordnete Scheibe nur auf der in Radialinwärtsrichtung nach unten abfallenden Oberfläche an der Oberseite der Vorsprünge aufliegt.

12. Haltevorrichtung für eine horizontal angeordnete Scheibe aus Halbleitermaterial gemäß einem der Ansprüche 1 bis 11, **dadurch gekennzeichnet, dass**
die Auflageelemente an ihrer radialinwärtsliegenden Seite zusätzlich Elemente zur Zentrierung der Scheibe aus Halbleitermaterial aufweisen, die im azimutalen Randbereich der radialinwärtsliegenden Seite angeordnet sind, und
die Elemente zur Zentrierung der Scheibe aus Halbleitermaterial als Vorsprünge mit einer kürzeren radialen und einer längeren axialen Ausdehnung im Vergleich zu den Vorsprüngen zur Randauflage der Scheibe aus Halbleitermaterial ausgestaltet sind.

13. Verwendung der Haltevorrichtung gemäß einem der Ansprüche 1 bis 12 in einem Messgerät zur Oberflächeninspektion, zur Kanteninspektion oder zur geometrischen Vermessung einer Scheibe aus Halbleitermaterial.

14. Verwendung der Haltevorrichtung gemäß dem Anspruch 13, wobei das Messgerät ein Streulichtinspektionsgerät zur Oberflächeninspektion einer Scheibe aus Halbleitermaterial ist.
